# EUROPEAN PATENT APPLICATION

(11) **EP 4 546 414 A1**
(43) Date of publication of application: **30.04.2025**
(21) Application number: 24194129.3
(22) Date of filing: 12.08.2024
(51) Int. Cl.: H01L 23/482, H01L 23/00

(54) **SEMICONDUCTOR DIE AND METHOD FOR FORMING THE SAME**

(30) Priority: 25.10.2023 US 202363593228 P; 02.04.2024 TW 113112604
(71) Applicant: Hon Young Semiconductor Corporation, Hsinchu City 300093 (TW)
(72) Inventor: Kuang-Hao, CHIANG, 300093 Hsinchu City (TW)
(74) Representative: Winter, Brandl - Partnerschaft mbB

(57) **Abstract**

A semiconductor die includes a plurality of first transistors and a second transistor. The first transistors are disposed in a peripheral area of the semiconductor die. Each of the first transistors has a first contact pad. In a top view, the first contact pad of each of the first transistors has a first outer edge in a hexagonal shape. The second transistor is disposed in a central area of the semiconductor die. The second transistor has a second contact pad. In the top view, the second contact pad has a second outer edge in a rectangular shape. The peripheral area surrounds the central area. The first contact pads of the first transistors collectively surround the second contact pad of the second transistor.

## Description

### BACKGROUND

### Field of Disclosure

The present disclosure relates to a semiconductor die and a method for forming the semiconductor die.

### Description of Related Art

Generally speaking, for a silicon carbide (SiC) metal oxide semiconductor field effect transistor (MOSFET), its gate pad, source pad, and drain pad are disposed in a rectangular shape. However, during semiconductor fabrication of a semiconductor die where MOSFETs are disposed, the peripheral area of the semiconductor die is more susceptible to stress and thermal damage than the central area of the semiconductor die. For example, contact pads disposed around corners and edges of the semiconductor die may experience stress cracking during die singulation. In addition, these contact pads are more susceptible to damage resulted from heat accumulation during packaging and reliability testing. This may reduce the reliability of the semiconductor die and is a major challenge in the thermal design of semiconductor devices.

### SUMMARY

According to some embodiments of the present disclosure, a semiconductor die includes a plurality of first transistors and a second transistor. The first transistors are disposed in a peripheral area of the semiconductor die. Each of the first transistors has a first contact pad. In a top view, the first contact pad of each of the first transistors has a first outer edge in a hexagonal shape. The second transistor is disposed in a central area of the semiconductor die. The second transistor has a second contact pad. In the top view, the second contact pad has a second outer edge in a rectangular shape. The peripheral area surrounds the central area. The first contact pads of the first transistors collectively surround the second contact pad of the second transistor.

According to some other embodiments of the present disclosure, a method for forming a semiconductor die includes providing a substrate having a peripheral area and a central area. The peripheral area surrounds the central area. The method further includes forming a plurality of first transistors in the peripheral area. Each of the first transistors has a first contact pad. In a top view, the first contact pad of each of the first transistors has a first outer edge in a hexagonal shape. The method further includes forming a second transistor in the central area. The second transistor has a second contact pad. In the top view, the second contact pad has a second outer edge in a rectangular shape. The first contact pads of the first transistors collectively surround the second contact pad of the second transistor.

Accordingly, in some embodiments of the semiconductor die and the method for forming the semiconductor die of the present disclosure, by setting the outer edges of the contact pads in the peripheral area to be in a hexagonal shape while maintaining the outer edges of the contact pads in the central area in a rectangular shape, problems of stress concentration and heat accumulation over the peripheral area can be mitigated. Thereby, the contact pads disposed in the peripheral area can be kept from cracking or failing. In addition, hexagonal contact pads have greater channel density and current density than rectangular contact pads, which helps reduce the on-state resistance per unit area of the transistors and therefore improve the leakage current of the transistors. Compared with common semiconductor dies and methods for forming the semiconductor dies, the reliability of the semiconductor device of the present disclosure can be improved.

### BRIEF DESCRIPTION OF THE DRAWINGS

The disclosure can be more fully understood by reading the following detailed description of the embodiment, with reference made to the accompanying drawings as follows:
FIG. 1 is a top view of a wafer according to some embodiments of the present disclosure;
FIG. 2 is a top view of a semiconductor die according to some embodiments of the present disclosure;
FIG. 3 is a partial cross-sectional view of a peripheral area of a semiconductor die taken along a line 3 in FIG. 2 according to some embodiments of the present disclosure;
FIG. 4 is a top view of a semiconductor die according to some embodiments of the present disclosure;
FIG. 5 is a top view of a semiconductor die according to some embodiments of the present disclosure;
FIG. 6 is a top view of a semiconductor die according to some other embodiments of the present disclosure; and
FIG. 7 is a top view of a semiconductor die according to yet some other embodiments of the present disclosure.

### DETAILED DESCRIPTION

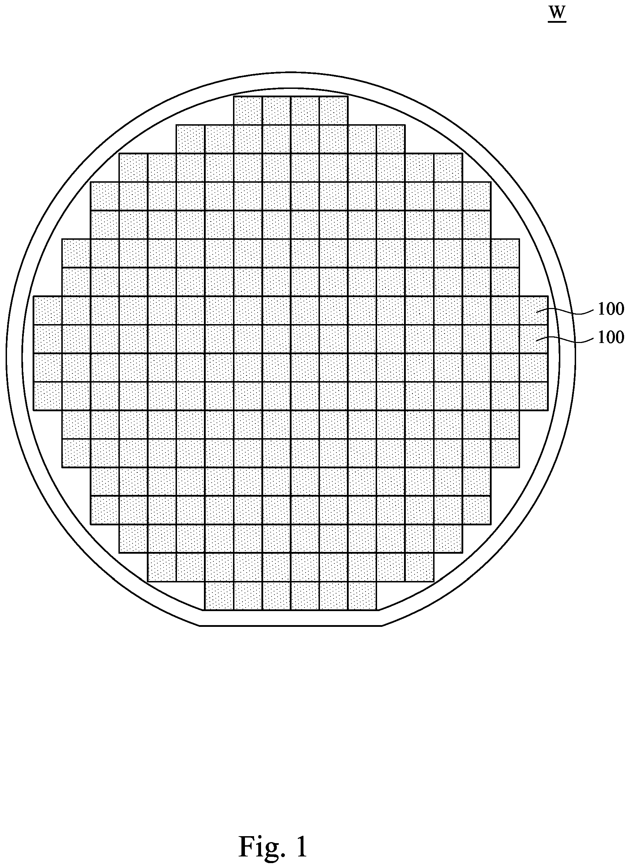

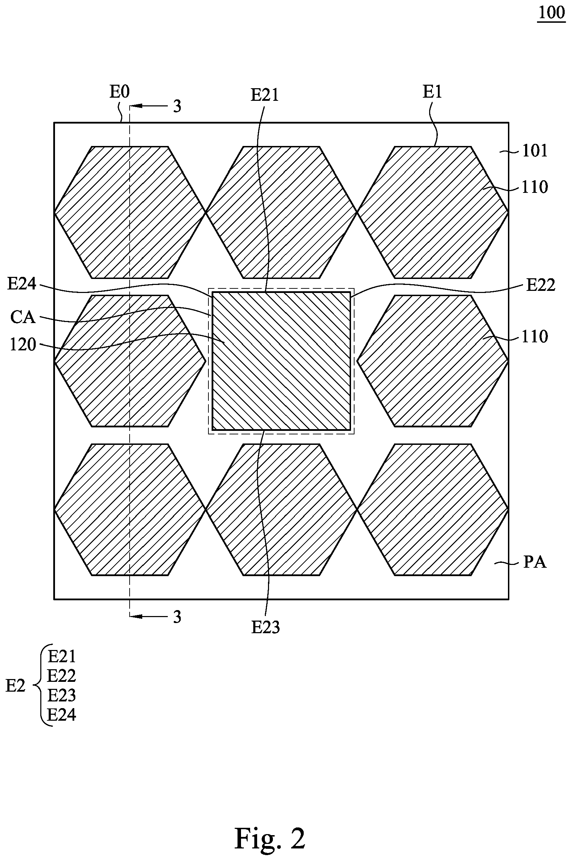

Reference is made to FIG. 1 and FIG. 2. FIG. 1 is a top view of a wafer W according to some embodiments of the present disclosure. FIG. 2 is a top view of a semiconductor die 100 according to some embodiments of the present disclosure. As shown in FIG. 1, the wafer W includes a plurality of semiconductor dies 100. As shown in FIG. 2, the semiconductor die 100 has a peripheral area PA and a central area CA. The peripheral area PA surrounds the central area CA. The peripheral area PA has an outermost edge E0 (i.e., an outermost edge of a substrate 101 of the semiconductor die 100). In some embodiments, the outermost edge E0 is rectangular.

In some embodiments, the semiconductor die 100 includes a plurality of first transistors (denoted by the first contact pads 110 of the first transistors in the figures) and a second transistor (denoted by the second contact pad(s) 120 of the second transistor(s) in the figures). As shown in FIG. 2, the first transistors are disposed substantially evenly in the peripheral area PA. The second transistor is disposed in the central area CA. Since the peripheral area PA surrounds the central area CA, the first contact pads 110 of the first transistors disposed in the peripheral area PA collectively surround the second contact pad 120 of the second transistor disposed in the central area CA. It should be understood that the first and second transistors have similar structures. Some subtle differences between the first and second transistors will be described in the following paragraphs accompanied with the figures.

Generally speaking, during fabrication, the first transistors in the peripheral area PA are more susceptible to stress and thermal damage than the second transistor(s) in the central area CA. Therefore, in some embodiments of the present disclosure, a structure that helps distribute stress and heat more evenly over the peripheral area PA is proposed.

In greater detail, each of the first transistors has at least one first contact pad 110. As shown in FIG. 2, each first contact pad 110 has a first outer edge E1 in a hexagonal shape. In some embodiments, the first contact pad 110 may be a source pad or a gate pad of the corresponding first transistor. In some embodiments, two first contact pads 110 may act as the source pad and the gate pad of the same first transistor, respectively. In some embodiments, two adjacent first contact pads 110 are separated from each other.

The second transistor has a second contact pad 120. As shown in FIG. 2, the second contact pad 120 has a second outer edge E2 in a rectangular shape. In some embodiments, the second contact pad 120 may be the source pad or the gate pad of the second transistor. In some embodiments, the second contact pad 120 of the second transistor is separated from the first contact pads 110 of the first transistors nearby.

Compared with the rectangular outer edges, the hexagonal outer edges have more straight edges and the included angle between two adjacent straight edges is larger. Therefore, the heat dissipation efficiency of the hexagonal outer edges can be higher than the heat dissipation efficiency of the rectangular outer edges. In addition, the channel density and current density of hexagonal contact pads are greater than those of rectangular contact pads. As a result, the on-state resistance (Rₒₙ) per unit area of the hexagonal contact pads is less, which helps improve the leakage current of the transistors.

As shown in FIG. 2, in order to disperse the heat around the periphery of the semiconductor die 100, at least a portion of one of the first transistors is disposed between the periphery of the second transistor and the outermost edge E0 of the semiconductor die 100. To be more specific, as shown in FIG. 2, the second outer edge E2 of the second contact pad 120 has a first straight edge E21, a second straight edge E22, a third straight edge E23, and a fourth straight edge E24, and the first contact pad 110 of a first one of the first transistors is disposed between the first straight edge E21 of the second outer edge E2 and the outermost edge E0. Similarly, the first contact pad 110 of a second one of the first transistors is disposed between the second straight edge E22 of the second outer edge E2 and the outermost edge E0, the first contact pad 110 of a third one of the first transistors is disposed between the third straight edge E23 of the second outer edge E2 and the outermost edge E0, and the first contact pad 110 of a fourth one of the first transistors is disposed between the fourth straight edge E24 of the second outer edge E2 and the outermost edge E0. In this way, the heat accumulated in the peripheral area PA will be dispersed through the hexagonal contact pads instead of being conducted to and accumulated around the corners or edges of the rectangular contact pads.

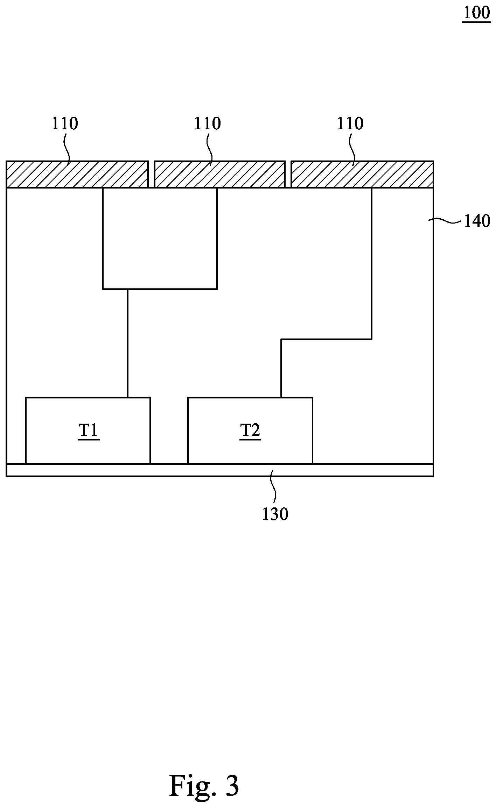

Reference is made to FIG. 3. FIG. 3 is a partial cross-sectional view of the peripheral area PA of the semiconductor die 100 taken along the line 3 in FIG. 2 according to some embodiments of the present disclosure. For the sake of clarity, the substrate 101 of the semiconductor die 100 is omitted in FIG. 3.

As shown in FIG. 3, the semiconductor die 100 further includes a drain pad 130 and a device layer 140. The device layer 140 includes a first transistor T1 and a first transistor T2. The first transistor T1 and the first transistor T2 include a source, a gate, and a drain, respectively. The source and the gate of the first transistor T1 are electrically connected upward to two first contact pads 110, respectively. The drain of the first transistor T1 is electrically connected downward to the drain pad 130. Similarly, one of the source and the gate of the first transistor T2 is electrically connected upward to another first contact pad 110, and the drain of the first transistor T2 is electrically connected downward to the drain pad 130. It should be noted that although the second transistor is not shown in the partial cross-sectional view, the second transistor is also disposed in the device layer 140 yet in the central area CA, and the configuration of the second transistor and the second contact pad 120 is similar to the configuration of the first transistor T2 and the first contact pad 110 shown in FIG. 3.

Reference is made to FIG. 2 and FIG. 3. The method for forming the semiconductor die 100 will be described in the following paragraphs accompanied with FIG. 2 and FIG. 3.

First, a substrate 101 is provided. As shown in FIG. 2, the substrate 101 has a peripheral area PA and a central area CA. The peripheral area PA surrounds the central area CA.

Then, a plurality of first transistors is formed in the peripheral area PA. As shown in FIG. 2, each of the first transistors has at least one first contact pad 110. In the top view of FIG. 2, the first outer edge E1 of each of the first contact pads 110 is hexagonal. These first contact pads 110 can be used as the sources and/or the gates of the first transistors. In some embodiments, as shown in FIG. 3, the first contact pads 110 are disposed on an upper surface of the device layer 140.

Next, the first contact pads 110 are coupled to a gate voltage or a source voltage based on their electrical connection relationship with the first transistors.

Then, a second transistor is formed in the central area CA. As shown in FIG. 2, the second transistor has a second contact pad 120. The first transistors collectively surround the second transistor. The first contact pads 110 collectively surround the second contact pad 120. In the top view, the second outer edge E2 of the second contact pad 120 is rectangular. Similarly, the second contact pad 120 can be used as the source or the gate of the second transistor and can be disposed on the upper surface of the device layer 140.

Next, the second contact pad 120 is coupled to a gate voltage or a source voltage based on its electrical connection relationship with the second transistor.

Furthermore, a drain pad 130 is formed on a lower surface of the device layer 140, as shown in FIG. 3. In some embodiments, the drain pad 130 is formed on the entire lower surface of the device layer 140. Later, the drain pad 130 may be coupled to a drain voltage.

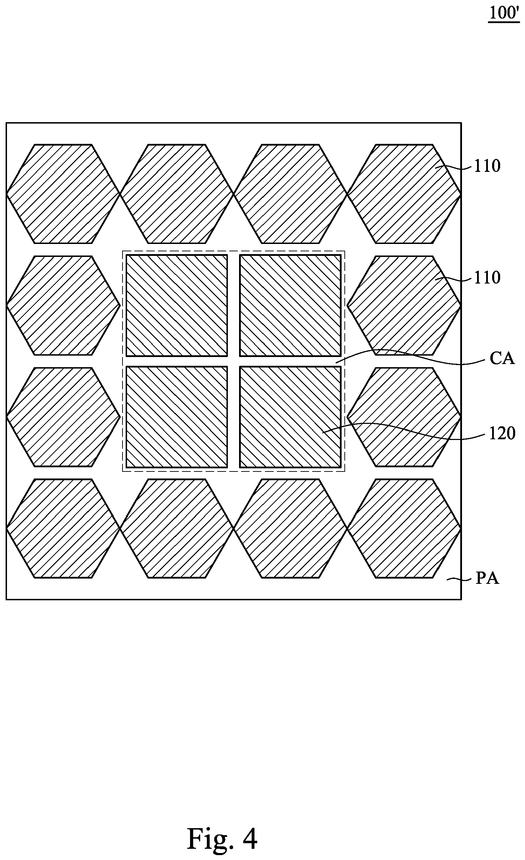

FIG. 4 is a top view of a semiconductor die 100' according to some embodiments of the present disclosure. The difference between the semiconductor die 100' and the semiconductor die 100 is that the semiconductor die 100' includes a plurality of second transistors in the central area CA. As shown in FIG. 4, the semiconductor die 100' includes four second contact pads 120. The first contact pads 110 collectively surround the four second contact pads 120.

It should be noted that, similar to the semiconductor die 100, at least one of the first contact pads 110 is disposed between the periphery of each of the second contact pads 120 and the outermost edge E0 of the semiconductor die 100', so that the heat can be evenly distributed.

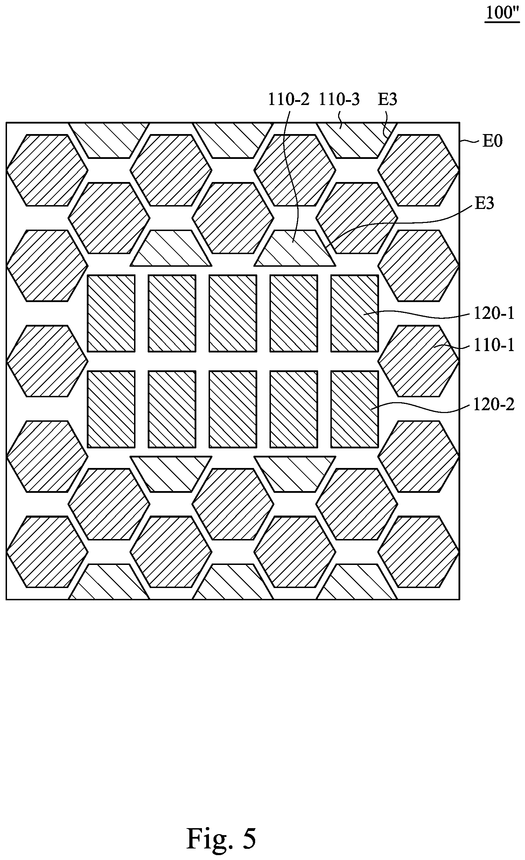

FIG. 5 is a top view of a semiconductor die 100" according to some embodiments of the present disclosure. One of the differences between the semiconductor die 100" and the semiconductor die 100' is that the first contact pads (such as the hexagonal first contact pads 110-1) of the semiconductor die 100" are staggered to increase the distribution density.

Furthermore, to achieve a denser arrangement, in some embodiments, the first contact pads may partially extend between two second contact pads. For example, the first contact pad 110-1 denoted in FIG. 5 extends between the second contact pad 120-1 and the second contact pad 120-2.

Accordingly, in some embodiments, the method for forming the semiconductor die 100" may further include forming a plurality of second transistors in the central area, such that the first contact pad 110-1 of one of the first transistors extends between the second contact pad 120-1 of one second transistor and the second contact pad 120-2 of another second transistor to achieve a higher distribution density.

Another difference between the semiconductor die 100" and the semiconductor die 100' is that the semiconductor die 100" further includes a third transistor in the peripheral area. In some embodiments, the third transistor is disposed between the first transistor and the second transistor. In some embodiments, the third transistor is disposed between the first transistor and the outermost edge E0. The third transistor and the first transistors collectively surround the second transistor.

In some embodiments, the third transistor has a third contact pad 110-2. As shown in FIG. 5, the third contact pad 110-2 is surrounded by the first contact pads and the second contact pads. In the top view, the third contact pad 110-2 has a third outer edge E3 in a trapezoidal shape. The bottom side (i.e., the long base) of the trapezoidal third outer edge E3 is disposed close to the second contact pad. Similar to the first contact pads, the third contact pad 110-2 may be the source or the gate of the third transistor. Similarly, the third transistor may be disposed in a device layer similar to the device layer 140 in FIG. 3 as with the first and second transistors, the configuration of the third transistor and the third contact pad 110-2 is similar to the configuration of the first transistor T2 and the first contact pad 110, and the third contact pad 110-2 may be disposed on the upper surface of the device layer.

In some embodiments, the third transistor has a third contact pad 110-3. As shown in FIG. 5, the third contact pad 110-3 is disposed between the first contact pads and the outermost edge E0. In the top view, the third contact pad 110-3 has a third outer edge E3 that is in a trapezoidal shape. The bottom side (i.e., the long base) of the trapezoidal third outer edge E3 is disposed close to or coincides with the outermost edge E0. Similarly, the third contact pad 110-3 can be used as the source or the gate of the third transistor.

Accordingly, in some embodiments, the method for forming the semiconductor die 100" may further include forming a third transistor in the peripheral area and between the first transistors and the second transistors. In some embodiments, the method for forming the semiconductor die 100" may further include forming a third transistor in the peripheral area between the first transistors and the outermost edge E0. In addition, the method for forming the semiconductor die 100" further includes coupling the third contact pad to a gate voltage or a source voltage.

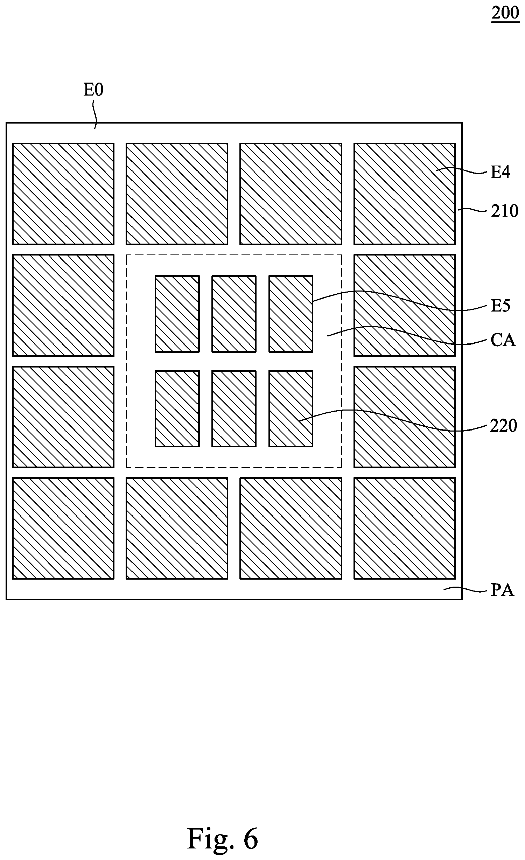

Reference is made to FIG. 6. FIG. 6 is a top view of a semiconductor die 200 according to some other embodiments of the present disclosure. One difference between the semiconductor die 200 and the semiconductor die 100 is that, as shown in FIG. 6, each of the first contact pads 210 of the semiconductor die 200 has a fourth outer edge E4 in a rectangular shape, and each of the second contact pads 220 of the semiconductor die 200 has a fifth outer edge E5 in a rectangular shape. To be more specific, the fourth outer edge E4 is substantially square, and the fifth outer edge E5 is an elongated rectangle. In some embodiments, every side length of the fourth outer edge E4 is greater than every side length of the fifth outer edge E5.

In addition, the other difference between the semiconductor die 200 and the semiconductor die 100 is that, as shown in FIG. 6, the minimum distance between the first contact pads 210 and the second contact pads 220 of the semiconductor die 200 is greater than the minimum distance between the first contact pads 110 and the second contact pads 120 of the semiconductor die 100. By adjusting the characteristic lengths and distribution density of the contact pads in the central area and the peripheral area, the current density can be controlled, thereby improving the heat distribution and stress distribution.

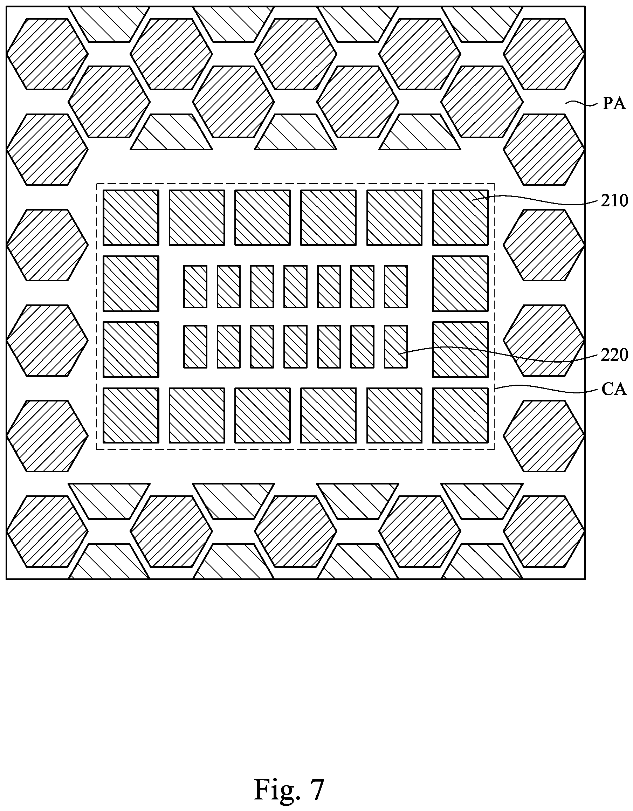

Reference is made to FIG. 7. FIG. 7 is a top view of a semiconductor die according to yet some other embodiments of the present disclosure. In these embodiments, the features of the semiconductor die 100 and the semiconductor die 200 can be combined. Thus, hexagonal contact pads and trapezoidal contact pads can be provided in the peripheral area PA, while rectangular contact pads similar to the first contact pad 210 and the second contact pad 220 of the semiconductor die 200 can be provided in the central area CA, in which the first contact pads 210 collectively surround the second contact pads 220 in the central area CA. As such, the heat distribution in the central area CA can be further optimized.

According to the foregoing recitations of the embodiments of the disclosure, it may be seen that in some embodiments of the semiconductor die and the method for forming the semiconductor die of the present disclosure, by setting the outer edges of the contact pads in the peripheral area to be in a hexagonal shape while maintaining the outer edges of the contact pads in the central area in a rectangular shape, problems of stress concentration and heat accumulation over the peripheral area can be mitigated. Thereby, the contact pads disposed in the peripheral area can be kept from cracking or failing. In addition, hexagonal contact pads have greater channel density and current density than rectangular contact pads, which helps reduce the on-state resistance per unit area of the transistors and therefore improve the leakage current of the transistors. Compared with common semiconductor dies and methods for forming the semiconductor dies, the reliability of the semiconductor device of the present disclosure can be improved.

## Claims

1. A semiconductor die, comprising:
a plurality of first transistors (T1, T2) disposed in a peripheral area (PA) of the semiconductor die, wherein each of the first transistors (T1, T2) has a first contact pad (110, 110-1, 210), wherein in a top view, the first contact pad (110, 110-1, 210) of each of the first transistors (T1, T2) has a first outer edge (E1) in a hexagonal shape; and
a second transistor disposed in a central area (CA) of the semiconductor die and having a second contact pad (120, 120-1, 120-2, 220), wherein in the top view, the second contact pad (120, 120-1, 120-2, 220) has a second outer edge (E2) in a rectangular shape,
wherein the peripheral area (PA) surrounds the central area (CA) and the first contact pads (110, 110-1, 210) of the first transistors (T1, T2) collectively surround the second contact pad (120, 120-1, 120-2, 220) of the second transistor.

2. The semiconductor die according to claim 1, wherein the semiconductor die (100, 100', 100", 200) has an outermost edge (E0), and the second outer edge (E2) of the second contact pad (120, 120-1, 120-2, 220) has a first straight edge (E21), a second straight edge (E22), a third straight edge (E23), and a fourth straight edge (E24), wherein at least a portion of a first one of the first transistors is disposed between the first straight edge (E21) and the outermost edge (E0), at least a portion of a second one of the first transistors is disposed between the second straight edge (E22) and the outermost edge (E0), at least a portion of a third one of the first transistors is disposed between the third straight edge (E23) and the outermost edge (E0), and at least a portion of a fourth one of the first transistors is disposed between the fourth straight edge (E24) and the outermost edge (E0).

3. The semiconductor die according to claim 1 or 2, further comprising another second transistor in the central area (CA), wherein the first contact pad (110-1) of one of the first transistors extends between the second contact pad (120-1) of the second transistor and the second contact pad (120-2) of the another second transistor.

4. The semiconductor die according to claim 1 or 2, wherein the first contact pad (110, 110-1, 210) of each of the first transistors (T1, T2) is a source pad or a gate pad.

5. The semiconductor die according to claim 1 or 2, wherein the second contact pad (120, 120-1, 120-2, 220) of the second transistor is a source pad or a gate pad.

6. The semiconductor die according to claim 1, further comprising a third transistor in the peripheral area (PA) and having a third contact pad (110-2), wherein in the top view, the third contact pad (110-2) has a third outer edge (E3) in a trapezoidal shape, and the third contact pad (110-2) of the third transistor is disposed between the second contact pad (120-1, 120-2, 220) of the second transistor and the first contact pad (110, 110-1) of one of the first transistors.

7. The semiconductor die according to claim 1, further comprising a third transistor in the peripheral area (PA) and having a third contact pad (110-2, 110-3), wherein in the top view, the third contact pad (110-2, 110-3) has a third outer edge (E3) in a trapezoidal shape, and the third contact pad (110-2, 110-3) of the third transistor is disposed between an outermost edge (E0) of the semiconductor die and the first contact pad (110, 110-1, 210) of one of the first transistors.

8. The semiconductor die according to claim 6 or 7, wherein the third contact pad (110-2, 110-3) of the third transistor is a source pad or a gate pad.

9. A method for forming a semiconductor die, comprising:
providing a substrate having a peripheral area (PA) and a central area (CA), wherein the peripheral area (PA) surrounds the central area (CA);
forming a plurality of first transistors (T1, T2) in the peripheral area (PA), wherein each of the first transistors (T1, T2) has a first contact pad (110, 110-1, 210), and in a top view, the first contact pad (110, 110-1, 210) of each of the first transistors (T1, T2) has a first outer edge (E1) in a hexagonal shape; and
forming a second transistor in the central area (CA), wherein the second transistor has a second contact pad (120, 120-1, 120-2, 220), and in the top view, the second contact pad (120, 120-1, 120-2, 220) has a second outer edge (E2) in a rectangular shape,
wherein the first contact pads (110, 110-1, 210) of the first transistors (T1, T2) collectively surround the second contact pad (120, 120-1, 120-2, 220) of the second transistor.

10. The method according to claim 9, further comprising forming another second transistor in the central area (CA), wherein the first contact pad (110-1) of one of the first transistors extends between the second contact pad (120-1) of the second transistor and the second contact pad (120-2) of the another second transistor.

11. The method according to claim 9 or 10, further comprising coupling the first contact pad (110, 110-1, 210) of each of the first transistors (T1, T2) to a gate voltage or a source voltage.

12. The method according to claim 9 or 10, further comprising coupling the second contact pad (120, 120-1, 120-2, 220) of the second transistor to a gate voltage or a source voltage.

13. The method according to claim 9, further comprising forming a third transistor in the peripheral area (PA), wherein the third transistor has a third contact pad (110-2), and in the top view, the third contact pad (110-2) has a third outer edge (E3) in a trapezoidal shape, and the third contact pad (110-2) of the third transistor is disposed between the second contact pad (120-1, 120-2, 220) of the second transistor and the first contact pad (110, 110-1) of one of the first transistors.

14. The method according to claim 9, further comprising forming a third transistor in the peripheral area (PA), wherein the third transistor has a third contact pad (110-2, 110-3), and in the top view, the third contact pad (110-2, 110-3) has a third outer edge (E3) in a trapezoidal shape, and the third contact pad (110-2, 110-3) of the third transistor is disposed between an outermost edge (E0) of the substrate and the first contact pad (110, 110-1, 210) of one of the first transistors.

15. The method according to claim 13 or 14, further comprising coupling the third contact pad (110-2, 110-3) of the third transistor to a gate voltage or a source voltage.
